# EUROPÄISCHE PATENTSCHRIFT

(11) **EP 3 688 833 B1**
(45) Veröffentlichungstag und Bekanntmachung des Hinweises auf die Patenterteilung: **21.06.2023**
(21) Anmeldenummer: 18766174.9
(22) Anmeldetag: 04.09.2018
(51) Int. Cl.: H01M 10/42, H01R 4/04, H05K 1/02, C09J 9/02, H05K 1/11, H05K 3/32

(54) **BAUGRUPPE, ENERGIESPEICHER**
ASSEMBLY, STORED-ENERGY SOURCE
MODULE, ACCUMULATEUR D'ÉNERGIE

(30) Priorität: 25.09.2017 DE 102017216912
(43) Veröffentlichungstag der Anmeldung: 05.08.2020
(73) Patentinhaber: Robert Bosch GmbH, 70442 Stuttgart (DE)
(72) Erfinder: TEPASS, Bernd, 71717 Beilstein (DE); WELSCH, Wolfgang, 69121 Heidelberg (DE)
(86) Internationale Anmeldenummer: PCT/EP2018/073699
(87) Internationale Veröffentlichungsnummer: WO 2019/057479

(56) Entgegenhaltungen:
- DE-A1-102009 050 315
- US-A- 4 377 619
- US-A1- 2015 138 739

## Beschreibung

Die Erfindung betrifft eine Baugruppe, insbesondere einen elektrischen Energiespeicher, mit zumindest einem elektrischen/elektronischen Bauelement, das zwei elektrische leitfähige Kontaktanschlüsse aufweist, die auf jeweils einer elektrisch leitfähigen Kontaktstelle zumindest eines Substrats mittels eines Silber aufweisenden Leitklebers befestigt ist.

Weiterhin betrifft die Erfindung einen Energiespeicher mit zumindest einer Galvanischen Zelle, die eine Anode und eine Kathode aufweist, und mit wenigstens einer Baugruppe, wie sie vorstehend beschrieben wurde.

### Stand der Technik

Baugruppen der eingangs genannten Art sind aus dem Stand der Technik bekannt. Häufig werden elektrische Bauelemente auf Leiterplatten beziehungsweise Substraten durch elektrisch leitende Kleber beziehungsweise Leitkleber befestigt. Aus technischen und kommerziellen Gründen ist dabei häufig Silber ein Bestandteil des Leitklebers. Die Verwendung von silberhaltigen Leitklebern zur elektrisch leitenden Befestigung von Bauelementen ist beispielsweise aus der Patentschrift US 4,377,619 A, der Offenlegungsschrift US 2015/138739 A1 oder der Offenlegungsschrift DE 10 2009 050315 A1 bekannt. Liegt Feuchtigkeit oder Wasser vor, so ionisiert dieses jedoch bei anliegender elektrischer Spannung. Entsprechend der angelegten Spannung beginnt das Wandern von Silber-Ionen von einer ersten der Kontaktstellen zu einer zweiten der Kontaktstellen, wobei das Silber in der zweiten Kontaktstelle zu neutralem Silber reduziert wird. Als Folge lagert sich zunehmend Silbermaterial an der zweiten Kontaktstelle an. Wenn genügend Silbermaterial zwischen der ersten Kontaktstelle und der zweiten Kontaktstelle vorliegt, bildet sich ein Nebenschluss, also ein paralleler Widerstand von der ersten Kontaktstelle zur zweiten Kontaktstelle zum Bauelement, der die Funktion des Bauelements beeinträchtigen kann. Um das Wandern von Silber-Ionen zu verhindern, schlägt die Patentschrift US 4,377,619 A vor, eine Polymerschicht zwischen den Kontaktstellen vorzusehen. Gemäß der US 2015/138739 A1 ist eine Adhäsivschicht vorgesehen, die wandernde Silber-Ionen mittels Metallionenfängern bindet.

### Offenbarung der Erfindung

Die elektrische Baugruppe mit den Merkmalen des Anspruchs 1 hat den Vorteil, dass der Nebenschluss und somit eine Beeinträchtigung der elektrischen Funktion des Bauelements verhindert werden. Durch eine vorteilhafte Maßnahme wird die Migration des Silbers aus dem Leitkleber durch die vorliegende Erfindung unterbunden. Dies wird dadurch erreicht, dass das Substrat zumindest eine zumindest zwischen den beiden Kontaktstellen angeordnete Einrichtung zum Neutralisieren eines auf den Leitkleber wirkenden elektrischen Feldes an wenigstens einer der Kontaktstellen aufweist. Durch das Neutralisieren des elektrischen Feldes wird erreicht, dass die Silber-Ionen keinen Anlass mehr haben, von der ersten Kontaktstelle zu der zweiten Kontaktstelle zu migrieren. In Folge dessen lagert sich an der zweiten Kontaktstelle kein Silbermaterial an und der Nebenschluss wird sicher verhindert. Insbesondere sind die Kontaktstellen als Kontaktflächen ausgebildet, auf welchen das Bauelement aufgeklebt ist.

Erfindungsgemäß ist eine erste der Kontaktstellen einer Anode und eine zweite der Kontaktstellen einer Kathode zugeordnet, wobei die Einrichtung der ersten Kontaktstelle zugeordnet ist. Bei der Anode und Kathode kann es sich um Anode oder Kathode einer Galvanischen Zelle handeln, jedoch können Anode und Kathode auch allgemein als Ursprung der Silber-Ionen (Anode) und Empfänger der Silber-Ionen (Kathode) verstanden werden. Dadurch, dass die Einrichtung der ersten Kontaktstelle zugeordnet ist, wird verhindert, dass Silber-Ionen in Richtung der zweiten Kontaktstelle migrieren können, sodass bereits am Ursprung eine Migration der Silber-Ionen vorteilhaft verhindert wird.

Gemäß einer ersten Variante ist erfindungsgemäß vorgesehen, dass die Einrichtung eine Leiterbahn aufweist, die die Kontaktstelle zumindest im Wesentlichen ringförmig umgibt. Durch die Leiterbahn wird ein elektrisches Feld erzeugt, das dem eigentlichen elektrischen Feld der Baugruppe entgegenwirkt und dadurch das eigentliche elektrische Feld neutralisiert. Hierdurch ist auf besonders einfache Art und Weise gewährleistet, dass keine Migration von Silber-Ionen von der ersten Kontaktstelle zu der zweiten Kontaktstelle erfolgt.

Insbesondere ist die Leiterbahn elektrisch mit der ersten Kontaktstelle verbunden. Hierüber erhält die erste Kontaktstelle das notwendige Spannungspotential, um das elektrische Feld zu neutralisieren.

Weiterhin ist bevorzugt vorgesehen, dass die Leiterbahn einstückig mit der ersten Kontaktstelle ausgebildet ist. Die erste Kontaktstelle wird somit von der ersten Leiterbahn mitgebildet, beispielsweise als von der ersten, ringförmigen Leiterbahn radial nach innen ragende Kontaktlasche oder -Zunge. Hierdurch ist eine einfache und kostengünstige Realisierung des Nebenschluss-Schutzes gewährleistet.

Bevorzugt handelt es sich bei dem Substrat um eine Leiterplatte. In diesem Fall ist die Leiterbahn vorteilhafterweise wie bei Leiterplatten üblich auf die Leiterplatte aufgedruckt oder aufgebracht. Damit ist eine kostengünstige Integration der Leiterbahn beziehungsweise der Einrichtung gewährleistet.

Alternativ zu der ersten Variante ist gemäß einer zweiten Variante erfindungsgemäß vorgesehen, dass das Substrat ein elektrisch leitfähiger Anschlussrahmen ist, und dass die Einrichtung wenigstens eine der ersten Kontaktstelle zugeordnete Aussparung aufweist, die beabstandet zu der ersten Kontaktstelle ausgebildet ist. Dadurch, dass die Aussparung beabstandet zu der ersten Kontaktstelle liegt, verbleibt ein Steg zwischen der Aussparung und der ersten Kontaktstelle. Dieser Steg wirkt entsprechend der Leiterbahn auf der Leiterplatte und neutralisiert das auf die Silber-Ionen wirkende elektrische Feld.

Dadurch ist ebenfalls eine einfache und sichere Verhinderung des Nebenschlusses zwischen den Kontaktstellen gewährleistet.

Der elektrische Energiespeicher mit den Merkmalen des Anspruchs 8 zeichnet sich durch die erfindungsgemäße Baugruppe aus. Es ergeben sich hierdurch die bereits genannten Vorteile. Weitere Vorteile und bevorzugte Merkmale ergeben sich insbesondere aus dem zuvor Beschriebenen sowie aus den Ansprüchen.

Im Folgenden soll die Erfindung anhand der Zeichnung näher erläutert werden. Dazu zeigen
- Figur 1: eine vorteilhafte Baugruppe in einer vereinfachten Darstellung,
- Figur 2: eine vorteilhafte Weiterbildung der Baugruppe gemäß einem ersten Ausführungsbeispiel und
- Figur 3: eine vorteilhafte Weiterbildung der Baugruppe gemäß einem zweiten Ausführungsbeispiel.

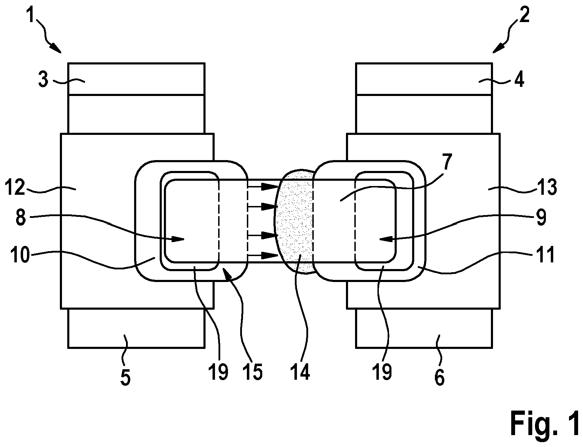

Figur 1 zeigt eine elektrische Baugruppe 1 eines elektrischen Speichers 2, der eine Anode 3 und eine Kathode 4 aufweist. Anode 3 und Kathode 4 sind jeweils ein Anschlussrahmen 5 beziehungsweise 6 zugeordnet. Diese sind durch ein elektrisches Bauelement 7 der Baugruppe 1 elektrisch miteinander verbunden. Das Bauelement 7 weist zumindest zwei Kontaktanschlüsse 8, 9 auf, die jeweils einer Kontaktstelle 10 beziehungsweise 11 des jeweiligen Anschlussrahmens 5, 6 zugeordnet sind. Die elektrisch leitfähigen Kontaktstellen 10, 11 sind dabei entweder direkt an dem Anschlussrahmen 5, 6 angeordnet beziehungsweise ausgebildet, oder auf einer jeweiligen Leiterplatte 12, 13, die zwischen Anschlussrahmen 5, 6 und Bauelement 7 zwischengeschaltet ist. Die Leiterplatten 12, 13 oder die Anschlussrahmen 5, 6 (Lead Frames) bilden dann entsprechend jeweils ein Substrat, welches die jeweilige Kontaktstelle 10, 11 trägt.

Insbesondere kann es sich bei den Leiterplatten 12, 13 um eine gemeinsame Leiterplatte handeln, die in Figur 1 aus Übersichtlichkeitsgründen getrennt dargestellt ist.

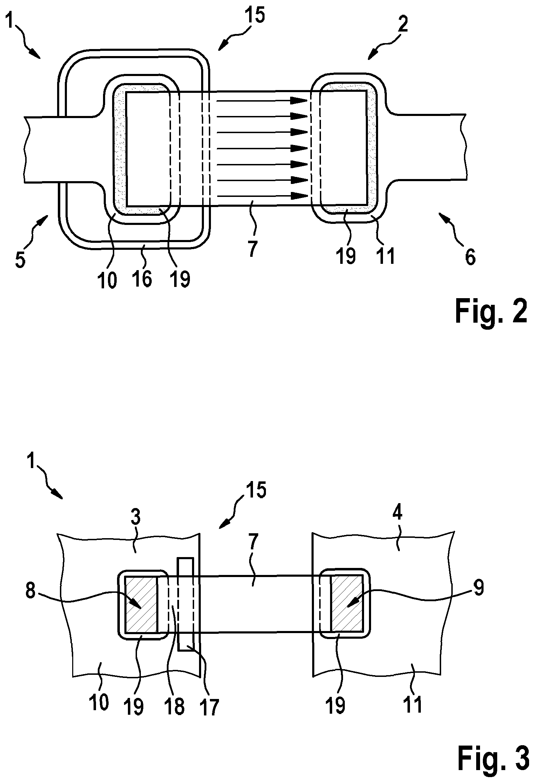

Zur sicheren Kontaktierung und Befestigung des Bauelements 7 ist dieses an den Kontaktstellen 10, 11 mittels jeweils eines Leitklebers 19, der Silber-Anteile enthält, insbesondere Silber-Leitkleber oder Epoxid-Klebstoff mit Silber-Partikeln gefüllt, befestigt. Liegt eine elektrische Spannung an und Feuchtigkeit vor, so beginnen Silber-Ionen des Leitklebers von der Kontaktstelle 10, die der Anode zugeordnet ist, zu der Kontaktstelle 11, die der Kathode zugeordnet ist, zu wandern. An der Kathode 4 beziehungsweise an der Kontaktstelle 11 wird der leitende Kleber zu Silber als Metall reduziert, wodurch sich eine an der Kathode 4 beziehungsweise an der Kontaktstelle 11 liegende Silbermasse 14 bildet und in Richtung der Anode beziehungsweise der Kontaktstelle 10 wächst, wie in Figur 1 gezeigt. Damit dies verhindert wird und ein dadurch entstehender elektrischer Nebenschluss parallel zu dem Bauelement 7, werden die in Figuren 2 und 3 vorgestellten Lösungen vorgesehen, durch welche verhindert wird, dass die Silber-Ionen von der Kontaktstelle 10 zu der Kontaktstelle 11 wandern.

Dazu weist die Baugruppe 1 eine Einrichtung 15 auf, welche das elektrische Feld, das in Figur 1 durch Pfeile gezeigt ist, und welches die Silber-Ionen in Richtung der Kathode 4 bewegt, neutralisiert wird. Dies wird dadurch erreicht, dass die der Anode 3 zugeordnete Kontaktstelle 10 in ihrer näheren Umgebung keinem elektrischen Feld ausgesetzt ist.

Gemäß dem Ausführungsbeispiel von Figur 2 weist die Einrichtung 15 dazu eine Leiterbahn 16 auf, welche die Kontaktstelle 10 ringförmig umgibt, sodass sie zumindest abschnittsweise zwischen den beiden Kontaktstellen 10 und 11 angeordnet ist, wobei sie näher zu der Kontaktstelle 10 liegt, sodass dort das elektrische Feld neutralisiert wird. Die Leiterbahn 16 ist dabei einstückig mit der Kontaktstelle 10 ausgebildet, die insbesondere als Kontaktfläche einer einstückig mit der Leiterbahn 16 ausgebildeten Kontaktzunge gebildet ist. Dadurch liegt an der Leiterbahn 16 das gleiche elektrische Potential an, wie an der Kontaktstelle 10, sodass das elektrische Feld im Bereich des Leitklebers 19 neutralisiert wird.

Die Leiterbahn 16 ist dabei derart angeordnet/ausgebildet, dass alle Flächen, die als Auflage für das Bauelement oder für den leitenden Kleber 19 dienen, räumlich hinter beziehungsweise innerhalb des Rings liegen, von der Kontaktstelle 11 aus betrachtet. Die Anbindung des Rings beziehungsweise der Leiterbahn 16 kann einer beliebigen Stelle der Anode 3 des Bauelements 7 erfolgen. Dadurch, dass durch die vorteilhafte Ausbildung keine Potentialdifferenz an der Anode anliegt, gibt es keinen Treiber für die Bewegung der Silber-Ionen, die ansonsten dem elektrischen Feld, gemäß der Pfeile in Figur 1, folgen würden. Mit der Unterbindung des Silber-lonen-Stroms findet an der Kathode 4 keine Reduktion zu Silber als Metall statt, sodass auch kein Anwachsen von Silber-Anlagerungen beziehungsweise der Silber-Masse 14 an der Kathode in Richtung der Anode erfolgt. Im Ergebnis wird somit ein elektrischer Nebenschluss zu dem Bauelement 7 sicher verhindert.

Sind die Kontaktstellen 10, 11 direkt an dem Anschlussrahmen 5 beziehungsweise 6 ausgebildet, wie in Figur 3 gezeigt, so weist die Einrichtung 15 bevorzugt eine in dem Anschlussrahmen 5 ausgebildete Aussparung 17 auf, die beabstandet zu der Kontaktstelle 10 liegt, sodass zwischen der Kontaktstelle 10 und der Aussparung 17 ein Steg 18 verbleibt, der die gleiche Wirkung hat, wie die ringförmige Leiterbahn 16. Somit wird auch in dieser in dem zweiten Ausführungsbeispiel gemäß Figur 3 der Silber-lonen-Strom in Richtung der Kathode beziehungsweise der Kontaktstelle 11 sicher verhindert.

## Patentansprüche

1. Baugruppe (1), insbesondere elektrischer Energiespeicher (2), mit zumindest einem elektrischen/elektronischen Bauelement (7), das zwei elektrisch leitfähige Kontaktanschlüsse (8,9) aufweist, die auf jeweils einer elektrisch leitfähigen Kontaktstelle (10,11) zumindest eines Substrats mittels eines Silber aufweisenden Leitklebers (19) befestigt sind, wobei eine erste der Kontaktstellen (10) einer Anode (3) und eine zweite der Kontaktstellen (11) einer Kathode (4) zugeordnet ist, **dadurch gekennzeichnet, dass** das Substrat zumindest eine zumindest zwischen den beiden Kontaktstellen (10,11) angeordnete Einrichtung (15) zum Neutralisieren eines auf den Leitkleber (19) wirkenden elektrischen Feldes an wenigstens einer der Kontaktstellen (10,11) aufweist, wobei entweder das Substrat ein Anschlussrahmen (5,6) ist und die Einrichtung (15) wenigstens eine der ersten Kontaktstelle (10) zugeordnete Aussparung (17) aufweist, die beabstandet zu der ersten Kontaktstelle (10) ausgebildet ist, sodass ein Steg zum Neutralisieren des elektrischen Feldes verbleibt, oder die Einrichtung (15) eine Leiterbahn (16) aufweist, die die erste Kontaktstelle (10) zumindest im Wesentlichen ringförmig umgibt.

2. Baugruppe nach einem der vorhergehenden Ansprüche, **dadurch gekennzeichnet, dass** die Leiterbahn (16) elektrisch mit der ersten Kontaktstelle (10) verbunden ist.

3. Baugruppe nach einem der vorhergehenden Ansprüche, **dadurch gekennzeichnet, dass** die Leiterbahn (16) einstückig mit der ersten Kontaktstelle (10) ausgebildet ist.

4. Baugruppe nach einem der vorhergehenden Ansprüche, **dadurch gekennzeichnet, dass** das Substrat eine Leiterplatte (12,13) ist.

5. Elektrischer Energiespeicher (2) mit zumindest einer Galvanischen Zelle, die eine Anode (3) und eine Kathode (4) aufweist, und mit zumindest einer Baugruppe (1) nach einem der Ansprüche 1 bis 4.

## Claims

1. Assembly (1), in particular electrical energy store (2), comprising at least one electrical/electronic component (7) having two electrically conductive contact terminals (8, 9), which are secured on respective electrically conductive contact points (10, 11) of at least one substrate by means of a conductive adhesive (19) comprising silver, a first of the contact points (10) being assigned to an anode (3) and a second of the contact points (11) being assigned to a cathode (4), **characterized in that** the substrate comprises at least one device (15) arranged between the two contact points (10, 11) and serving for neutralizing an electric field acting on the conductive adhesive (19) at at least one of the contact points (10, 11), either the substrate being a leadframe (5, 6) and the device (15) comprising at least one cutout (17) which is assigned to the first contact point (10) and which is formed at a distance from the first contact point (10), such that a web remains for neutralizing the electric field, or the device (15) comprising a conductor track (16) surrounding the first contact point (10) at least substantially in ring-shaped fashion.

2. Assembly according to any of the preceding claims, **characterized in that** the conductor track (16) is electrically connected to the first contact point (10).

3. Assembly according to either of the preceding claims, **characterized in that** the conductor track (16) is formed in one piece with the first contact point (10).

4. Assembly according to any of the preceding claims, **characterized in that** the substrate is a printed circuit board (12, 13).

5. Electrical energy store (2) comprising at least one galvanic cell having an anode (3) and a cathode (4), and comprising at least one assembly (1) according to any of Claims 1 to 4.

## Revendications

1. Module (1), en particulier accumulateur d'énergie électrique (2), comprenant au moins un composant électrique/électronique (7) qui présente deux bornes de contact (8, 9) électriquement conductrices qui sont fixées à respectivement un point de contact (10, 11) électriquement conducteur d'au moins un substrat au moyen d'un adhésif conducteur (19) contenant de l'argent, dans lequel un premier des points de contact (10) est associé à une anode (3) et un deuxième des points de contact (11) est associé à une cathode (4),
**caractérisé en ce que** le substrat présente au moins un dispositif (15) disposé au moins entre les deux points de contact (10, 11) pour neutraliser un champ électrique agissant sur l'adhésif conducteur (19) au niveau d'au moins l'un des points de contact (10, 11), dans lequel soit le substrat est un cadre de raccordement (5, 6) et le dispositif (15) présente au moins un évidement (17) associé au premier point de contact (10) qui est réalisé de façon espacée par rapport au premier point de contact (10) de sorte qu'il reste une entretoise pour neutraliser le champ électrique, soit le dispositif (15) présente une piste conductrice (16) qui entoure le premier point de contact (10) au moins de manière substantiellement annulaire.

2. Module selon l'une quelconque des revendications précédentes, **caractérisé en ce que** la piste conductrice (16) est reliée électriquement au premier point de contact (10).

3. Module selon l'une quelconque des revendications précédentes, **caractérisé en ce que** la piste conductrice (16) est réalisée d'un seul tenant avec le premier point de contact (10).

4. Module selon l'une quelconque des revendications précédentes, **caractérisé en ce que** le substrat est une carte de circuits imprimés (12, 13).

5. Accumulateur d'énergie électrique (2), comprenant au moins une cellule galvanique qui présente une anode (3) et une cathode (4), et comprenant au moins un module (1) selon l'une quelconque des revendications 1 à 4.
